# EUROPÄISCHE PATENTSCHRIFT

(11) **EP 2 593 973 B1**
(45) Veröffentlichungstag und Bekanntmachung des Hinweises auf die Patenterteilung: **22.11.2017**
(21) Anmeldenummer: 11725748.5
(22) Anmeldetag: 16.06.2011
(51) Int. Cl.: H01L 33/60, H01L 33/46, H01L 33/50, H01L 33/62, H01L 33/56, H01L 33/20

(54) **OPTOELEKTRONISCHES HALBLEITERBAUTEIL**
OPTOELECTRONIC SEMICONDUCTOR COMPONENT
COMPOSANT SEMI-CONDUCTEUR OPTOÉLECTRONIQUE

(30) Priorität: 15.07.2010 DE 102010027253
(43) Veröffentlichungstag der Anmeldung: 22.05.2013
(73) Patentinhaber: OSRAM Opto Semiconductors GmbH, 93055 Regensburg (DE)
(72) Erfinder: SCHNEIDER, Markus, 93152 Schönhofen (DE); RACZ, David, 93051 Regensburg (DE); RAMCHEN, Johann, 84032 Altdorf (DE)
(74) Vertreter: Epping - Hermann - Fischer
(86) Internationale Anmeldenummer: PCT/EP2011/060043
(87) Internationale Veröffentlichungsnummer: WO 2012/007245

(56) Entgegenhaltungen:
- EP-A1- 2 216 834
- WO-A1-2007/072659
- DE-C1- 10 245 946
- US-A1- 2004 089 898
- US-A1- 2010 140 648

## Beschreibung

Es wird ein optoelektronisches Halbleiterbauteil angegeben.

In der Druckschrift US 6,900,511 B2 ist eine optoelektronische Komponente und ein Herstellungsverfahren hierfür offenbart.

Es ist in der Druckschrift US 2010/0140648 A1 eine LED mit einem Verguss beschrieben.

Die Druckschrift WO 2007/072659 A1 betrifft eine LED.

Ein Lichtquellenmodul findet sich in der Druckschrift DE 102 45 946 C1.

Aus der Druckschrift EP 2 216 834 A1 ist eine LED mit einem Leuchtstoff und einem reflektierenden Verguss bekannt.

Eine zu lösende Aufgabe besteht darin, ein optoelektronisches Halbleiterbauteil anzugeben, das eine hohe Abstrahleffizienz aufweist.

Diese Aufgabe wird gelöst durch ein optoelektronisches Halbleiterbauteil mit den Merkmalen des Anspruchs 1.

Das optoelektronische Halbleiterbauteils beinhaltet einen Träger mit einer Trägeroberseite. Bei dem Träger handelt es sich zum Beispiel um eine Leiterplatte, insbesondere um eine bedruckte Leiterplatte und/oder um eine Metallkernplatine. Ebenso kann es sich bei dem Träger um eine bevorzugt mit Leiterbahnen versehene Keramik oder um ein mit Leiterbahnen versehenes, passiviertes Halbleitermaterial wie Silizium oder Germanium handeln. Weiterhin kann der Träger als so genanntes Quad-Flat No-Leads-Package, kurz QFN, ausgeführt sein.

Das Halbleiterbauteil umfasst einen oder mehrere optoelektronische Halbleiterchips, die an der Trägeroberseite angebracht sind. Der Halbleiterchip umfasst eine Halbleiterschichtenfolge, die zumindest eine aktive Schicht zur Erzeugung einer elektromagnetischen Strahlung aufweist. Weiterhin beinhaltet der zumindest eine Halbleiterchip ein strahlungsdurchlässiges Substrat, das bevorzugt transparent und klarsichtig ist. Bei dem Substrat kann es sich um ein Aufwachssubstrat für die Halbleiterschichtenfolge handeln. Ebenso ist es möglich, dass das Aufwachssubstrat von der Halbleiterschichtenfolge entfernt ist und dass es sich bei dem Substrat des Halbleiterchips um ein die Halbleiterschichtenfolge tragendes, nachträglich aufgebrachtes Substrat handelt, das von dem Aufwachssubstrat verschieden ist. Die Halbleiterschichtenfolge und/oder das bevorzugt transparente Substrat können mindestens stellenweise von einer strahlungsdurchlässigen Passivierungsschicht insbesondere unmittelbar umgeben sein.

Die Halbleiterschichtenfolge des Halbleiterchips basiert bevorzugt auf einem III-V-Verbindungshalbleitermaterial. Bei dem Halbleitermaterial handelt es sich zum Beispiel um ein Nitrid-Verbindungshalbleitermaterial wie AlₙIn₁₋ₙGaₘN oder um ein Phosphid-Verbindungshalbleitermaterial wie AlₙIn₁₋ₙGaₘP, wobei jeweils 0 ≤ n ≤ 1, 0 ≤ m ≤ 1 und n + m ≤ 1 ist. Dabei kann die Halbleiterschichtenfolge Dotierstoffe sowie zusätzliche Bestandteile aufweisen. Der Einfachheit halber sind jedoch nur die wesentlichen Bestandteile des Kristallgitters der Halbleiterschichtenfolge, also Al, Ga, In, N oder P, angegeben, auch wenn diese teilweise durch geringe Mengen weiterer Stoffe ersetzt und/oder ergänzt sein können. Die aktive Schicht beinhaltet insbesondere einen pn-Übergang und/oder mindestens eine Quantentopfstruktur.

Das Halbleiterbauteil weist ein reflektierendes Vergussmaterial auf. Reflektierend bedeutet, dass das Vergussmaterial für Strahlung im sichtbaren Spektralbereich eine Reflektivität von insbesondere mehr als 80 % oder von mehr als 90 %, bevorzugt von mehr als 94 % aufweist. Das Vergussmaterial reflektiert bevorzugt diffus. Für einen Betrachter erscheint das Vergussmaterial bevorzugt weiß.

Es umgibt das reflektierende Vergussmaterial den Halbleiterchip in einer lateralen Richtung ringsum. Es steht das Vergussmaterial ringsum in unmittelbarem Kontakt zu dem Halbleiterchip.

Es sind laterale Begrenzungsflächen des Halbleiterchips von dem reflektierenden Vergussmaterial bedeckt. Mit anderen Worten ist der Halbleiterchip in das reflektierende Vergussmaterial eingebettet.

Gemäß zumindest einer Ausführungsform des Halbleiterbauteils handelt es sich bei dem optoelektronischen Halbleiterchip um einen so genannten Volumenemitter. Das heißt, ohne zusätzliche Maßnahmen wie das reflektierende Vergussmaterial verlässt ein im Betrieb des Halbleiterchips erzeugter Strahlungsanteil, der beispielsweise mehr als 20 % oder mehr als 40 % einer insgesamt aus dem Halbleiterchip ausgekoppelten Strahlung beträgt, den Halbleiterchip über das strahlungsdurchlässige Substrat. Ohne zusätzliche Maßnahmen wie das Vergussmaterial wird im Betrieb des Halbleiterchips Strahlung also nicht nur an der Halbleiterschichtenfolge, sondern zu einem wesentlichen Teil auch an dem Substrat emittiert.

Das optoelektronische Halbleiterbauteil beinhaltet einen Träger mit einer Trägeroberseite. An der Trägeroberseite ist zumindest ein optoelektronischer Halbleiterchip angebracht. Der Halbleiterchip umfasst eine Halbleiterschichtenfolge mit mindestens einer aktiven Schicht zur Erzeugung einer elektromagnetischen Strahlung sowie ein strahlungsdurchlässiges Substrat. Weiterhin umfasst das Halbleiterbauteil ein reflektierendes Vergussmaterial, das, von der Trägeroberseite ausgehend, den Halbleiterchip in einer lateralen Richtung mindestens bis zu einer halben Höhe des Substrats ringsum umgibt.

Materialien für das Substrat wie Saphir oder Siliziumcarbid sind aufgrund ihres Kristallgitters und ihrer hohen thermischen Leitfähigkeit besonders geeignet, darauf Halbleiterschichtenfolgen zur Strahlungserzeugung anzubringen. Diese Materialien sind jedoch strahlungsdurchlässig. Somit verteilt sich im Betrieb des Halbleiterchips erzeugte Strahlung über den gesamten Halbleiterchip, insbesondere auch über das Substrat. Die im Betrieb erzeugte Strahlung wird deshalb auch durch Begrenzungsflächen des Substrats hindurch aus dem Halbleiterchip emittiert. Die aus dem Substrat emittierte Strahlung ist vergleichsweise ungerichtet und kann beispielsweise an dem Träger absorbiert werden. Durch das reflektierende Vergussmaterial, das das Substrat überwiegend umgibt, ist die über das Substrat austretende Strahlung in das Substrat zurück reflektierbar. Hierdurch ist eine Abstrahlungseffizienz des Halbleiterbauteils erhöhbar. Gemäß zumindest einer Ausführungsform des Halbleiterbauteils handelt es sich bei dem Halbleiterchip um eine Leuchtdiode, die Strahlung bevorzugt im nahen ultravioletten oder nahen infraroten Spektralbereich und/oder die sichtbares Licht wie blaues oder weißes Licht emittiert. Eine Dicke der Halbleiterschichtenfolge beträgt beispielsweise höchstens 12 µm oder höchstens 8 µm. Eine Dicke des strahlungsdurchlässigen Substrats beträgt beispielsweise zwischen einschließlich 40 µm und 500 µm, insbesondere zwischen einschließlich 50 µm und 200 µm.

Gemäß zumindest einer Ausführungsform des Halbleiterbauteils befindet sich das strahlungsdurchlässige Substrat zwischen dem Träger und der Halbleiterschichtenfolge. Die Halbleiterschichtenfolge ist also an einer dem Träger abgewandten Seite des Substrats angebracht. Eine Strahlungshauptseite des Halbleiterchips ist dann durch eine dem Substrat sowie dem Träger abgewandte Begrenzungsfläche der Halbleiterschichtenfolge beziehungsweise des Halbleiterchips gebildet.

Es sind laterale Begrenzungsflächen des Halbleiterchips ringsum und vollständig von dem reflektierenden Vergussmaterial bedeckt.

Das Halbleiterbauteil beinhaltet ein Konversionsmittel. Das Konversionsmittel ist dazu eingerichtet, eine in dem Halbleiterchip im Betrieb erzeugte Strahlung teilweise oder vollständig in eine Strahlung einer anderen Wellenlänge umzuwandeln. Das Konversionsmittel ist dem Halbleiterchip in einer Abstrahlrichtung nachgeordnet. Beispielsweise bedeckt das Konversionsmittel die Strahlungshauptseite teilweise oder vollständig zumindest mittelbar, in eine Richtung weg von dem Träger und senkrecht zu der Trägeroberseite. Das Konversionsmittel kann in unmittelbarem Kontakt zu der Strahlungshauptseite des Halbleiterchips stehen.

Es ist das Konversionsmittel als Schicht ausgebildet. Dies kann bedeuten, dass eine laterale Ausdehnung des Konversionsmittels eine Dicke des Konversionsmittels übersteigt. Beispielsweise liegt eine Dicke des Konversionsmittels zwischen einschließlich 10 µm und 150 µm, insbesondere zwischen einschließlich 15 µm und 50 µm.

Gemäß zumindest einer Ausführungsform des Halbleiterbauteils steht das Konversionsmittel in lateraler Richtung, also in einer Richtung parallel zu der Trägeroberseite, stellenweise oder vollständig in unmittelbarem Kontakt zum Vergussmaterial. Es können das Vergussmaterial und das Konversionsmittel in lateraler Richtung direkt aneinander grenzen.

Gemäß einer nicht erfindungsgemäßen Abwandlung schließen das Vergussmaterial und das Konversionsmittel bündig ab, in eine Richtung weg von der Trägeroberseite. Mit anderen Worten weisen dem Träger abgewandte Oberseiten des Vergussmaterials sowie des Konversionsmittels in dem Bereich, in dem sich das Vergussmaterial und das Konversionsmittel in einer lateralen Richtung am nächsten kommen und/oder sich berühren, einen gleichen Abstand zu der Trägeroberseite auf.

Es erstreckt sich das Vergussmaterial vollständig über die Strahlungshauptseite. Die Strahlungshauptseite ist also von dem Vergussmaterial bedeckt, in eine Richtung weg von der Trägeroberseite. Eine Dicke des Vergussmaterials über der Trägeroberseite beträgt bevorzugt höchstens 50 µm oder höchstens 20 µm. Es befindet sich zwischen dem Vergussmaterial über der Strahlungshauptseite und der Strahlungshauptseite selbst das Konversionsmittel. Das Vergussmaterial bedeckt dann sowohl den Halbleiterchip als auch das Konversionsmittel.

Gemäß einer nicht erfindungsgemäßen Abwandlung sind der Halbleiterchip sowie das Vergussmaterial, in eine Richtung senkrecht zu der Trägeroberseite, überwiegend oder vollständig von dem Konversionsmittel überdeckt. Überwiegend kann bedeuten, dass ein Bedeckungsgrad mehr als 75 % oder mehr als 90 % beträgt. Insbesondere sind der Halbleiterchip und das Vergussmaterial vollständig von dem Konversionsmittel zusammen mit mindestens einer elektrischen Anschlusseinrichtung überdeckt. Die elektrische Anschlusseinrichtung ist beispielsweise durch einen Bonddraht gebildet, der das Konversionsmittel durchdringt.

Gemäß zumindest einer Ausführungsform des Halbleiterbauteils ist über die mindestens eine elektrische Anschlusseinrichtung eine elektrische Verbindung zwischen dem Träger, insbesondere der Trägeroberseite oder auf der Trägeroberseite befindlicher elektrischer Anschlussbereiche, und der Strahlungshauptseite des Halbleiterchips hergestellt. Die Anschlusseinrichtung, die den Träger mit der Strahlungshauptseite verbindet, ist zumindest stellenweise in das reflektierende Vergussmaterial eingebettet, insbesondere bis zu einer dem Träger abgewandten Oberseite des Vergussmaterials. Das Vergussmaterial kann, in lateraler Richtung, die Anschlusseinrichtung ringsum unmittelbar und formschlüssig umgeben.

Es umgibt das Vergussmaterial den Halbleiterchip in lateraler Richtung ringsum unmittelbar und formschlüssig. Das Vergussmaterial kann an den Halbleiterchip angegossen sein. Gemäß zumindest einer Ausführungsform des Halbleiterbauteils ist eine oder sind mehrere elektrische Anschlusseinrichtungen stellenweise unmittelbar auf der dem Träger abgewandten Oberseite des Vergussmaterials und/oder des Konversionsmittels aufgebracht, beispielsweise über ein Sputtern oder ein Abscheiden aus der Gasphase. Die Anschlusseinrichtung beinhaltet dann wenigstens eine elektrisch leitfähige Schicht. Die elektrisch leitfähige Schicht der Anschlusseinrichtung ist bevorzugt über eine Durchkontaktierung durch das Vergussmaterial und/oder durch das Konversionsmittel hindurch mit dem Träger und/oder mit dem Halbleiterchip verbunden.

Gemäß zumindest einer Ausführungsform des Halbleiterbauteils verlässt ein im Betrieb des Halbleiterchips erzeugter Strahlungsanteil in lateraler Richtung das Substrats des Halbleiterchips und dringt in das Vergussmaterial ein. Eine Eindringtiefe beträgt beispielsweise mindestens 10 µm oder mindestens 30 µm. Bevorzugt beträgt die Eindringtiefe höchstens 300 µm oder höchstens 100 µm. Die Eindringtiefe ist zum Beispiel die Tiefe, parallel zu der Trägeroberseite, bei der eine Intensität der in das Vergussmaterial eindringenden Strahlung auf 1/e² abgefallen ist.

Gemäß zumindest einer Ausführungsform des Halbleiterbauteils ist das Vergussmaterial dazu eingerichtet, den in das Vergussmaterial eindringenden Strahlungsanteil mindestens teilweise diffus in das Substrat zurück zu reflektieren. Eine Teilstrahlung verlässt also das Substrat und/oder die Halbleiterschichtenfolge, dringt in das Vergussmaterial ein, wird von diesem reflektiert und gelangt anschließend wieder zurück in den Halbleiterchip und wird bevorzugt nachfolgend an der Strahlungshauptseite aus dem Halbleiterchip ausgekoppelt.

Gemäß zumindest einer Ausführungsform des optoelektronischen Halbleiterbauteils weisen die elektrischen Anschlussbereiche an der Trägeroberseite, die sich insbesondere lateral neben dem Halbleiterchip befinden, ein für im Betrieb des Halbleiterchips erzeugte Strahlung absorbierendes Material auf. Die Anschlussbereiche sind durch das Vergussmaterial von der im Halbleiterchip erzeugten Strahlung abgeschirmt. Beispielsweise weisen die Anschlussbereiche Gold auf und der Halbleiterchip emittiert Strahlung im blauen Spektralbereich.

Gemäß zumindest einer Ausführungsform des Halbleiterbauteils ist die Strahlungshauptseite und/oder die Oberseite des Konversionsmittels stellenweise oder vollständig mit einer Antihaftschicht bedeckt. Die Antihaftschicht ist dazu eingerichtet, ein Benetzen der Strahlungshauptseite und/oder der Oberseite des Konversionsmittels mit dem Vergussmaterial während der Herstellung des Halbleiterbauteils zu verhindern. Die Antihaftschicht weist zum Beispiel ein fluoriertes Polymer wie Polytetrafluorethylen auf.

Gemäß zumindest einer Ausführungsform des Halbleiterbauteils ist das Vergussmaterial dazu eingerichtet, einen Abstrahlwinkel der im Betrieb des Halbleiterbauteils erzeugten Strahlung zu verringern. Dies ist dadurch ermöglicht, dass das Vergussmaterial einen im Halbleiterchip erzeugten Strahlungsanteil, der diesen in einer lateralen Richtung verlässt, reduziert oder verhindert. Alternativ oder zusätzlich ist es möglich, dass eine Oberseite des Vergussmaterials als paraboloider oder hyperboloider Reflektor geformt ist.

Nachfolgend wird ein hier beschriebenes optoelektronisches Halbleiterbauteil unter Bezugnahme auf die Zeichnung anhand von Ausführungsbeispielen und nicht erfindungsgemäßen Abwandlungen näher erläutert. Gleiche Bezugszeichen geben dabei gleiche Elemente in den einzelnen Figuren an. Es sind dabei jedoch keine maßstäblichen Bezüge dargestellt, vielmehr können einzelne Elemente zum besseren Verständnis übertrieben groß dargestellt sein.

Es zeigen:
- Figuren 1, 3 bis 10 sowie 13: schematische Darstellungen von nicht erfindungsgemäßen Abwandlungen,
- Figur 11: eine schematische Schnittdarstellungen eines Ausführungsbeispiels eines hier beschriebenen optoelektronischen Halbleiterbauteils,

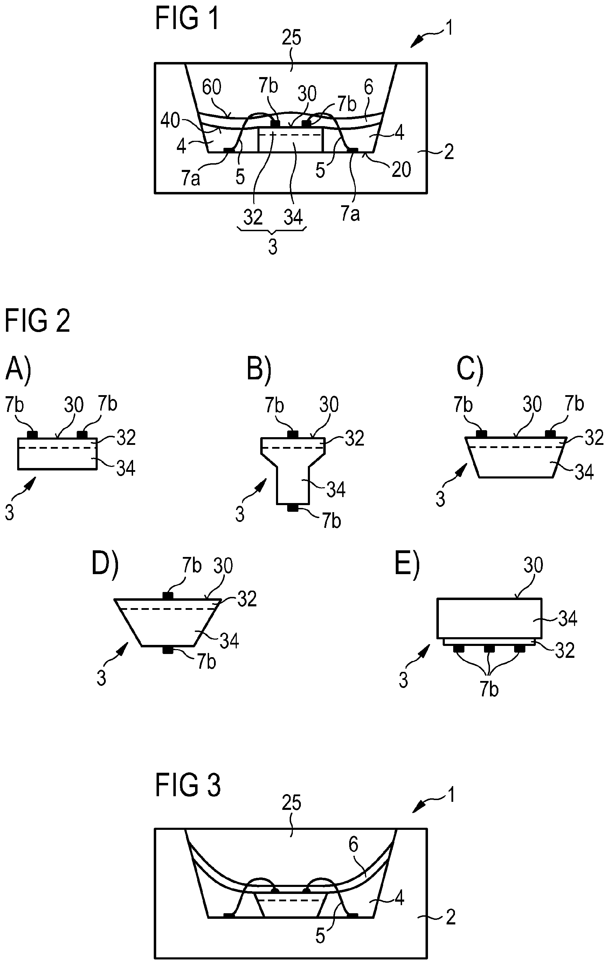

- Figur 2: schematische Seitenansicht von optoelektronischen Halbleiterchips für Ausführungsbeispiele von hier beschriebenen Halbleiterbauteilen,

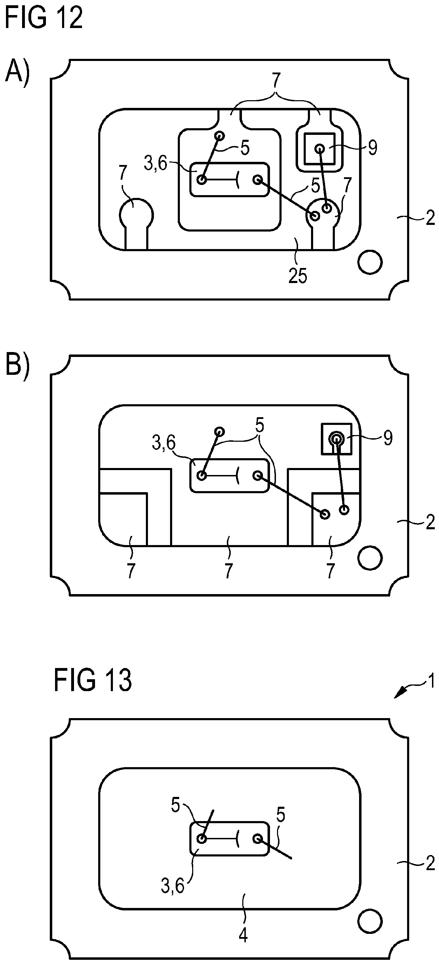

- Figur 12: schematische Darstellungen von Halbleiterbauteilen ohne Vergussmaterial, und

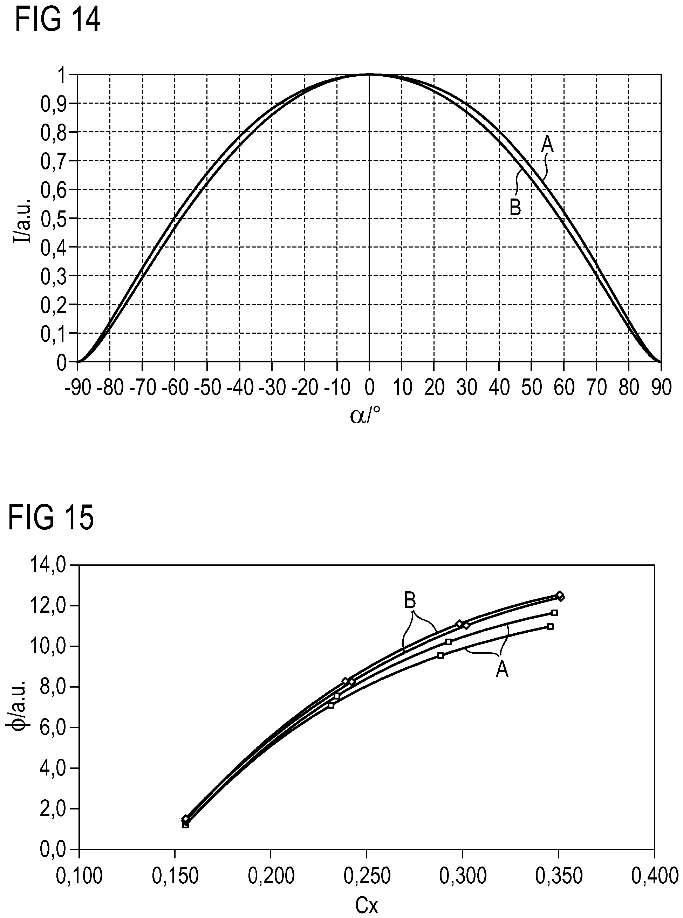

- Figuren 14 und 15: schematische Diagramme zu Abstrahleigenschaften von Ausführungsbeispielen von hier beschriebenen Halbleiterbauteilen.

In Figur 1 ist in einer schematischen Schnittdarstellung eine nicht erfindungsgemäße Abwandlung eines optoelektronischen Halbleiterbauteils 1 illustriert. Das Halbleiterbauteil 1 beinhaltet einen Träger 2, der eine Kavität 25 aufweist. Leiterbahnen des Trägers 2 sind in den Figuren nicht gezeichnet. Eine Bodenfläche der Kavität 25 stellt eine Trägeroberseite 20 dar. Auf der Trägeroberseite 20 ist ein optoelektronischer Halbleiterchip 3 aufgebracht. Der Halbleiterchip 3 weist eine Halbleiterschichtenfolge 32 mit einer aktiven Schicht zur Erzeugung einer elektromagnetischen Strahlung im Betrieb des Halbleiterchips 3 auf. Des Weiteren umfasst der Halbleiterchip 3 ein strahlungsdurchlässiges Substrat 34, an dem die Halbleiterschichtenfolge 32 angebracht ist. In den Figuren sind die Halbleiterschichtenfolge 32 sowie das strahlungsdurchlässige Substrat 34 jeweils schematisch durch eine Strich-Linie getrennt. Bei dem Halbleiterchip 3 handelt es sich jedoch um ein einziges, kompaktes, monolithisches Element, das als Einheit handhabbar und insbesondere als Einheit an der Trägeroberseite 20 montiert ist.

Der Halbleiterchip 3 ist über elektrische Anschlusseinrichtungen 5, die gemäß Figur 1 durch Bonddrähte gebildet sind, kontaktiert. Die Anschlusseinrichtungen 5 verbinden elektrische Anschlussbereiche 7a an der Trägeroberseite 20 mit elektrischen Anschlussbereichen 7b an einer Strahlungshauptseite 30 des Halbleiterchips 3.

In lateraler Richtung, parallel zu der Trägeroberseite 20, ist der Halbleiterchip 3 bis hin zur Strahlungshauptseite 30, von der Trägeroberseite 20 ausgehend, ringsum unmittelbar von einem reflektierenden Vergussmaterial 4 umgeben. Für einen Betrachter erscheint das Vergussmaterial 4 weiß, in ausgeschaltetem Zustand des Halbleiterchips 3. In eine Richtung weg von der Trägeroberseite 20 schließt das Vergussmaterial 4 bündig mit der Strahlungshauptseite 30 ab. Bis auf eine geringe Dickenschwankung aufgrund von Benetzungseffekten des Halbleiterchips 3 und von lateralen Begrenzungswänden der Kavität 25 weist das Vergussmaterial 4 eine konstante Höhe auf. Mit anderen Worten ist eine der Trägeroberseite 20 abgewandte Vergussoberseite 40 im Wesentlichen parallel zu der Trägeroberseite 20 orientiert. Zwischen der Trägeroberseite 20 und der Vergussoberseite 40 sind die Anschlusseinrichtung 5 in lateraler Richtung ringsum unmittelbar und formschlüssig vom Vergussmaterial 4 umgeben.

Auf der Vergussoberseite 40 ist mit einer im Wesentlichen konstanten Schichtdicke ein Konversionsmittel 6 mit einer Konversionsmitteloberseite 60 aufgebracht. Es verläuft die Konversionsmitteloberseite 60 nahezu in konstantem Abstand zu der Vergussoberseite 40. Die Anschlusseinrichtungen 5 sind nur teilweise in das Konversionsmittel 6 eingebettet. Es überragen die Anschlusseinrichtungen 5 die Konversionsmitteloberseite 60, in eine Richtung weg von der Trägeroberseite 20. Die gesamte Strahlungshauptseite 30 ist vollständig von dem Konversionsmittel 6, zusammen mit den Anschlusseinrichtungen 5, bedeckt. Das Konversionsmittel 6 füllt die Kavität 25 nur teilweise aus, sodass an einer dem Träger 2 abgewandten Seite der Konversionsmitteloberseite 60 in der Kavität 25 ein Freiraum verbleibt.

Bei dem reflektierenden Vergussmaterial 4 handelt es sich, wie auch in allen anderen Abwandlungen oder Ausführungsbeispielen, bevorzugt um ein Polymer, in das reflektierend wirkende Partikel eingefüllt sind. Das Polymer des Vergussmaterials 4, das eine Matrix für die Partikel bildet, ist zum Beispiel ein Silikon, ein Epoxid oder ein Silikon-Epoxid-Hybridmaterial. Die reflektierenden Partikel sind zum Beispiel aus einem Metalloxid wie Aluminiumoxid oder Titanoxid, aus einem Metallfluorid wie Calciumfluorid oder aus einem Siliziumoxid hergestellt oder bestehen daraus. Ein mittlerer Durchmesser der Partikel, beispielsweise ein Median-Durchmesser d₅₀ in Q₀, liegt bevorzugt zwischen einschließlich 0,3 µm und 5 µm. Ein Gewichtsanteil der Partikel an dem gesamten Vergussmaterial 4 beträgt bevorzugt zwischen einschließlich 5 % und 50 %, insbesondere zwischen einschließlich 10 % und 30 %. Die Partikel wirken reflektierend aufgrund ihrer bevorzugt weißen Farbe und/oder aufgrund ihres Brechungsindexunterschieds zu dem Matrixmaterial.

In Figur 2 sind schematische Seitenansichten von Halbleiterchips 3 für Halbleiterbauteile 1 illustriert. In allen Ausführungsbeispielen des Halbleiterbauteils 1 sind die in Figuren 2A bis 2E dargestellten Halbleiterchips 3 analog einsetzbar.

Der Halbleiterchip 3 gemäß Figur 2A weist die zwei elektrischen Anschlussbereiche 7b an der Strahlungshauptseite 30 an der Halbleiterschichtenfolge 32 auf. Laterale Begrenzungsflächen des Halbleiterchips 3 sind im Wesentlichen senkrecht zu der Strahlungshauptseite 30 orientiert. Das Substrat 34 ist zum Beispiel ein Saphirsubstrat.

Gemäß Figur 2B weist das Substrat 34 einen Sockelbereich mit einem verminderten Durchmesser sowie einen Kopfbereich mit einem vergrößerten Durchmesser auf, wobei auf dem Kopfbereich die Halbleiterschichtenfolge 32 angebracht ist. Eine elektrische Kontaktierung erfolgt über die Anschlussbereiche 7b an den einander gegenüberliegenden Hauptseiten des Halbleiterchips 3.

Bei dem Halbleiterchip 3 gemäß Figur 2C sind die Anschlussbereiche 7 an der Halbleiterschichtenfolge 32 an der Strahlungshauptseite 30 angebracht. In eine Richtung weg von der Strahlungshauptseite nimmt eine Breite des Halbleiterchips 3 ab. Beispielsweise ist der Halbleiterchip 3 wie ein Pyramidenstumpf geformt.

Beim Halbleiterchip 3 gemäß Figur 2D sind die Anschlussbereiche 7b, anders als in Figur 2C, an einander gegenüberliegenden Hauptseiten des Halbleiterchips 3 angebracht. Die Substrate 34 der Halbleiterchips 3 gemäß den Figuren 2B bis 2D sind insbesondere Siliziumcarbidsubstrate.

In Figur 2E ist der Halbleiterchip 3 mit mehr als zwei Anschlussbereichen 7b an der Halbleiterschichtenfolge 32 versehen. Der Halbleiterchip 3 gemäß Figur 2E ist dazu eingerichtet, so an dem Träger 2 montiert zu werden, dass sich die Halbleiterschichtenfolge 32 zwischen dem Träger 2, in Figur 2E nicht dargestellt, und dem Substrat 34 befindet. Die Strahlungshauptseite 30 ist durch eine der Halbleiterschichtenfolge 32 abgewandte Hauptfläche des Substrats 34 gebildet.

Bei der nicht erfindungsgemäßen Abwandlung gemäß Figur 3 wirkt das reflektierende Vergussmaterial 4 im Unterschied zu Figur 1 benetzend bezüglich der lateralen Begrenzungswände der Kavität 25. Hierdurch ist durch das Vergussmaterial 4 ein paraboloider Reflektor innerhalb der Kavität 25 realisiert. Die Schichtdicke des Konversionsmittels 6 ist über das gesamte Vergussmaterial 4 hinweg näherungsweise konstant.

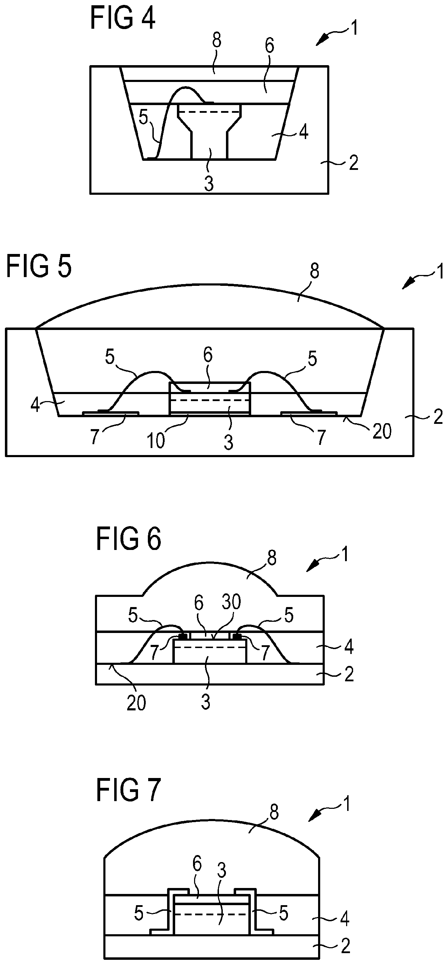

Bei der nicht erfindungsgemäßen Abwandlung des Halbleiterbauteils 1 gemäß Figur 4 ist die elektrische Anschlusseinrichtung 5 vollständig in das Konversionsmittel 6 zusammen mit dem Vergussmaterial 4 eingebettet. Die Anschlusseinrichtung 5 überragt das Konversionsmittel 6 nicht. Wie auch in den Figuren 1 und 3 sind das Vergussmaterial 4 sowie der Halbleiterchip 3, in eine Richtung weg von der Trägeroberseite 20, vollständig von dem Konversionsmittel 6 oder vollständig von dem Konversionsmittel 6 zusammen mit der Anschlusseinrichtung 5 überdeckt. Optional ist das Konversionsmittel 6 von einem Zusatzverguss 8, insbesondere vollständig, überdeckt, wobei der Zusatzverguss die Kavität 25 nicht überragt. Der Zusatzverguss 8 kann, wie auch in allen anderen Ausführungsbeispielen, klarsichtig und transparent sein oder auch ein Filtermittel und/oder einen Diffusor enthalten.

Bei der nicht erfindungsgemäßen Abwandlung des Halbleiterbauteils 1 gemäß Figur 5 ist der Zusatzverguss 8 als Linse ausgeformt. Das Konversionsmittel 6 ist als Plättchen gestaltet und auf die Strahlungshauptseite 30 begrenzt. Anders als in Figur 5 dargestellt, kann das Konversionsmittel 6 Aussparungen oder Öffnungen für die Anschlusseinrichtungen 5 aufweisen.

Die elektrischen Anschlussbereiche 7 an der Trägeroberseite 20 sind durch das reflektierende Vergussmaterial 4 von einer im Halbleiterchip 3 im Betrieb erzeugten und aus dem Halbleiterchip 3 ausgekoppelten Strahlung abgeschirmt. Hierdurch ist es möglich, dass die Anschlussbereiche 7 ein Material umfassen, das für die im Halbleiterchip 3 erzeugte Strahlung absorbierend wirkt. Beispielsweise weisen die Anschlussbereiche 7 korrosionsbeständiges Gold oder eine Goldlegierung auf.

Optional ist es möglich, wie auch in allen anderen Abwandlungen oder Ausführungsbeispielen, dass sich zwischen dem Halbleiterchip 3 und der Trägeroberseite 20 ein Spiegel 10 befindet. Beispielsweise umfasst oder besteht der Spiegel 10 aus einem reflektierenden Metall wie Silber. Alternativ oder zusätzlich kann der Spiegel 10 zumindest teilweise über Totalreflexion reflektieren.

In Figur 6 ist eine nicht erfindungsgemäße Abwandlung dargestellt, bei dem der Träger 2 keine Kavität aufweist sondern als planparallele Platte geformt ist. Das Konversionsmittel 6 ist als Plättchen gestaltet und auf die Strahlungshauptseite 30 aufgebracht, wobei die Anschlussbereiche 7 von dem Konversionsmittel 6 nicht bedeckt sind. Das Vergussmaterial 4 schließt, in eine Richtung weg von der Trägeroberseite 20, bündig mit dem Konversionsmittel 6 ab. In lateraler Richtung berühren sich das Konversionsmittel 6 und das Vergussmaterial 7 ringsum unmittelbar. Die Anschlussbereiche 7 sind von dem Vergussmaterial 4 vollständig bedeckt. Anders als in Figur 6 dargestellt ist es möglich, dass die Anschlusseinrichtungen 5 das Vergussmaterial 4 in eine Richtung weg von der Trägeroberseite 20 nicht überragen und vollständig in das Vergussmaterial 4 eingebettet sind.

Bei der nicht erfindungsgemäßen Abwandlung gemäß Figur 7 sind die Anschlusseinrichtungen 5 durch Beschichtungen unmittelbar an dem Halbleiterchip 3 erzeugt. Eine Durchkontaktierung zwischen den Anschlusseinrichtungen 5 und dem Halbleiterchip 3 durch das Konversionsmittel 6 hindurch ist in Figur 7 nicht gezeichnet. Zur Vermeidung elektrischer Kurzschlüsse umfasst der Halbleiterchip 3 bevorzugt zumindest an lateralen Begrenzungsflächen eine elektrisch isolierende Schicht.

In eine Richtung weg von dem Träger 2 folgt gemäß den Figuren 6 und 7 dem Halbleiterchip 3 sowie dem Konversionsmittel 6 und dem Vergussmaterial 4 der Zusatzverguss 8 nach. Der Zusatzverguss 8 weist einen als Linse geformten Bereich auf, der sich über einen Teil des Zusatzvergusses 8, siehe Figur 6, oder über den gesamten Zusatzverguss 8, wie in Figur 7, erstreckt.

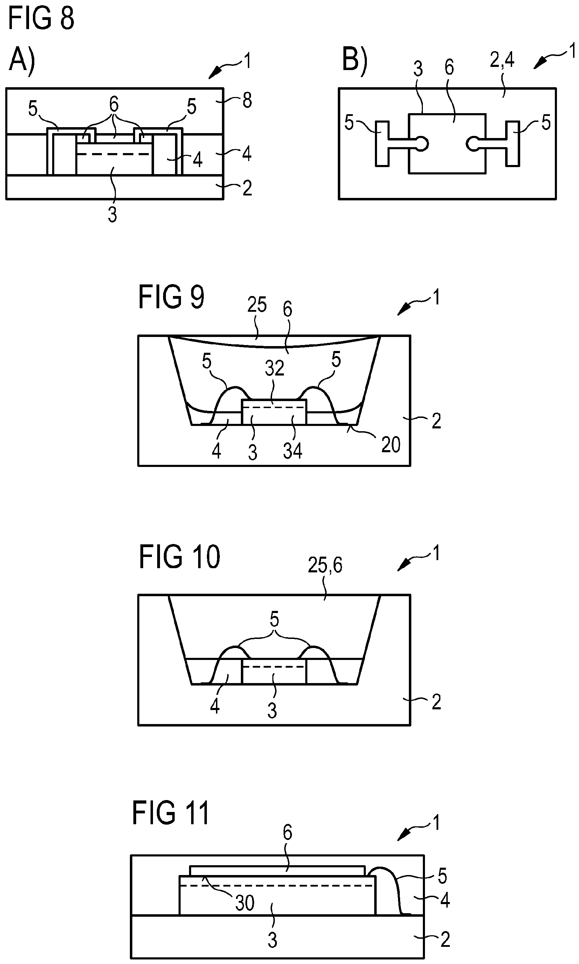

In Figur 8A ist eine Schnittdarstellung und in Figur 8B eine Draufsicht auf eine weitere nicht erfindungsgemäße Abwandlung des Halbleiterbauteils 1 dargestellt. In lateraler Richtung befinden sich zwischen den Anschlusseinrichtungen 5 und dem Halbleiterchip 3 Teile des Vergussmaterials 4. Eine Isolierung zwischen dem Halbleiterchip 3 und den Anschlusseinrichtungen 5 in lateraler Richtung erfolgt also durch das Vergussmaterial 4. Die Anschlusseinrichtungen 5 sind unmittelbar auf das Vergussmaterial 4 sowie auf das Konversionsmittel 6 aufgebracht und über Durchkontaktierungen mit dem Halbleiterchip 3 und dem Träger 2 elektrisch verbunden.

Bei der nicht erfindungsgemäßen Abwandlung gemäß Figur 9 reicht das Vergussmaterial 4 nicht bis an die Halbleiterschichtenfolge 32 heran. Das Konversionsmittel 6 ist als Volumenverguss ausgestaltet und weist eine Dicke bevorzugt zwischen einschließlich 100 µm und 500 µm auf. Anders als in Figur 9 dargestellt ist es möglich, dass das Konversionsmittel 6 die Kavität 25 überragt.

Bei der nicht erfindungsgemäßen Abwandlung gemäß Figur 10 füllt das Konversionsmittel 6 die Kavität 25 des Trägers 2 vollständig aus und schließt, in eine Richtung weg von der Trägeroberseite 20, bündig mit dem Träger 2 ab.

Gemäß dem Ausführungsbeispiel der Figur 11 ist das Konversionsmittel 6 als Schicht unmittelbar oder als Plättchen mittelbar, über ein nicht dargestelltes Verbindungsmittel insbesondere angeklebt, auf die Strahlungshauptseite 30 aufgebracht. Sowohl der Halbleiterchip 3 als auch das Konversionsmittel 6 sind vollständig von dem Vergussmaterial 4, in eine Richtung weg von dem Träger 2, überdeckt. Mit anderen Worten sind der Halbleiterchip 3 und das Konversionsmittel 6 vollständig von dem Träger 2 und dem Vergussmaterial 4 ringsum eingeschlossen. Eine Schichtdicke des Vergussmaterials 4 über dem Konversionsmittel 6 ist bevorzugt klein und beträgt zum Beispiel höchstens 50 µm, so dass Strahlung aus dem Halbleiterchip 3 sowie konvertierte Strahlung aus dem Konversionsmittel 6 das Vergussmaterial 4 in dem Bereich über der Strahlungshauptseite 30 das Halbleiterbauteil 1 verlassen kann.

In den Figuren 12A sowie 12B sind Bauteile ohne Vergussmaterial gezeigt. Wie in allen Abwandlungen oder Ausführungsbeispielen können die Halbleiterbauteile 1 Schutzdioden 9 zum Schutz gegen elektrostatische Entladung aufweisen. In der nicht erfindungsgemäßen Abwandlung gemäß Figur 13 sind die Halbleiterbauteile 1 aus den Figuren 12A und 12B mit dem Vergussmaterial 4 gezeigt. Durch das Vergussmaterial 4 sind die Anschlusseinrichtungen 5 nur unvollständig überdeckt, die Schutzdiode ist in das Vergussmaterial 4 eingebettet+. Ebenso sind der Halbleiterchip 3 sowie das Konversionsmittel 6 frei von dem Vergussmaterial 4. Das Vergussmaterial 4 reicht ringsum von dem Halbleiterchip 3 bis zu den Begrenzungswänden der Kavität.

In Figur 14 ist eine Abstrahlintensität I gegenüber einem Abstrahlwinkel α für die Bauteile gemäß Figur 12, siehe die Kurve A, sowie für das Halbleiterbauteil 1 gemäß Figur 13, siehe die Kurve B, illustriert. Durch den reflektierenden Verguss 4 weist das Halbleiterbauteil 1 einen engeren Abstrahlwinkelbereich auf, im Vergleich zu einem identischen Bauteil ohne Vergussmaterial.

In Figur 15 ist ein Lichtstrom Φ in willkürlichen Einheiten gegenüber einer Farbkoordinate cₓ der CIE-Normfarbtafel dargestellt. Die Kurven A entsprechen Bauteilen ohne Vergussmaterial, die Kurven B entsprechen Halbleiterbauteilen 1 mit dem Vergussmaterial 4. Der Lichtstrom Φ ist in den Kurven B gegenüber den Kurven A um mehrere Prozentpunkte erhöht. Durch das Vergussmaterial 4 ist also eine Effizienz des Halbleiterbauteils 1 steigerbar.

Die hier beschriebene Erfindung ist nicht durch die Beschreibung anhand der Ausführungsbeispiele beschränkt.

## Patentansprüche

1. Optoelektronisches Halbleiterbauteil (1) mit
- einem Träger (2) mit einer Trägeroberseite (20),
- mindestens einem auf der Trägeroberseite (20) angebrachten optoelektronischen Halbleiterchip (3) mit einem strahlungsdurchlässigen Substrat (34) und mit einer Halbleiterschichtenfolge (32), die wenigstens eine aktive Schicht zur Erzeugung einer elektromagnetischen Strahlung aufweist,
- einem als Schicht unmittelbar oder als Plättchen über ein Verbindungsmittel mittelbar auf einer dem Träger (2) abgewandten Strahlungshauptseite (30) des Halbleiterchips (3) aufgebrachten Konversionsmittel (6) zu einer wenigstens teilweisen Umwandlung der von dem Halbleiterchip (3) emittierten Strahlung in eine Strahlung einer anderen Wellenlänge, und
- einem reflektierenden Vergussmaterial (4), das den Halbleiterchip (3) in einer lateralen Richtung ringsum unmittelbar und formschlüssig umgibt,
**dadurch gekennzeichnet, dass**
sich zwischen dem Vergussmaterial (4) und der Strahlungshauptseite (30) das Konversionsmittel (6) befindet, sodass sowohl der Halbleiterchip (3) als auch das Konversionsmittel (6) vollständig von dem Vergussmaterial (4) überdeckt sind.

2. Optoelektronisches Halbleiterbauteil (1) nach dem vorhergehenden Anspruch,
bei dem sich das Substrat (34) zwischen dem Träger (2) und der Halbleiterschichtenfolge (32) befindet, und das mindestens eine elektrische Anschlusseinrichtung (5) umfasst, die eine elektrische Verbindung zwischen der Trägeroberseite (20) oder auf der Trägeroberseite (20) befindlicher elektrischer Anschlussbereiche und der Strahlungshauptseite (30) herstellt.

3. Optoelektronisches Halbleiterbauteil (1) nach einem der vorhergehenden Ansprüche,
bei dem das Konversionsmittel (6) eine größere laterale Ausdehnung als eine Dicke aufweist und die Dicke zwischen einschließlich 10 µm und 150 µm liegt.

4. Optoelektronisches Halbleiterbauteil (1) nach einem der vorhergehenden Ansprüche,
bei dem der Träger (2) eine Kavität (25) aufweist und eine Bodenfläche der Kavität (25) die Trägeroberseite (20) darstellt,
wobei sich der Halbleiterchip (3) und das Vergussmaterial (4) in der Kavität (25) befinden, wobei das reflektierende Vergussmaterial (4) benetzend bezüglich lateraler Begrenzungswände der Kavität (25) wirkt, sodass durch das Vergussmaterial (4) ein paraboloider Reflektor innerhalb der Kavität (25) realisiert ist.

5. Optoelektronisches Halbleiterbauteil (1) nach einem der vorhergehenden Ansprüche,
bei dem eine Dicke der Halbleiterschichtenfolge (32) höchstens 12 µm beträgt und eine Dicke des strahlungsdurchlässigen Substrats (34) zwischen einschließlich 40 µm und 500 µm beträgt.

6. Optoelektronisches Halbleiterbauteil (1) nach den Ansprüchen 2 und 3,
bei dem, in eine Richtung senkrecht zu der Trägeroberseite (20), der Halbleiterchip (3) sowie das Vergussmaterial (4) von der elektrischen Anschlusseinrichtung (5), die das Konversionsmittel (6) durchdringt, überdeckt sind.

7. Optoelektronisches Halbleiterbauteil (1) nach einem der Ansprüche 1 bis 5,
bei dem die Anschlusseinrichtung (5) mindestens stellenweise in das Vergussmaterial (4) eingebettet ist.

8. Optoelektronisches Halbleiterbauteil (1) nach zumindest Anspruch 2,
bei dem das Vergussmaterial (4) den Halbleiterchip (4) und die mindestes eine elektrische Anschlusseinrichtung (5) in lateraler Richtung mindestens stellenweise unmittelbar und formschlüssig umgibt.

9. Optoelektronisches Halbleiterbauteil (1) nach zumindest Anspruch 2,
bei dem die elektrische Anschlusseinrichtung (5) stellenweise unmittelbar auf einer dem Träger abgewandten Oberseite (40) des Vergussmaterials (4) aufgebracht ist.

10. Optoelektronisches Halbleiterbauteil (1) nach den Ansprüchen 2 und 3,
bei dem die elektrische Anschlusseinrichtung (5) stellenweise unmittelbar auf einer dem Träger abgewandten Oberseite (60) des Konversionsmittels (6) aufgebracht ist.

11. Optoelektronisches Halbleiterbauteil (1) nach Anspruch 2,
bei dem die elektrischen Anschlussbereich (7) an der Trägeroberseite (20) lateral neben dem Halbleiterchip (3) angeordnet sind und ein für im Betrieb des Halbleiterchips (3) erzeugte Strahlung absorbierendes Material aufweisen,
wobei die elektrischen Anschlussbereiche (7) durch das Vergussmaterial (4) von der Strahlung abgeschirmt sind.

12. Optoelektronisches Halbleiterbauteil (1) nach einem der vorhergehenden Ansprüche,
bei dem die Strahlungshauptseite (30) stellenweise oder vollständig mit einer Antihaftschicht bedeckt sind, die dazu eingerichtet ist, ein Benetzen der Strahlungshauptseite (30) mit dem Vergussmaterial (4) zu verhindern.

13. Optoelektronisches Halbleiterbauteil (1) nach einem der vorhergehenden Ansprüche,
bei dem das Vergussmaterial (4) dazu eingerichtet ist, einen Abstrahlwinkel der im Betrieb des Halbleiterchips (3) erzeugten Strahlung zu verringern.

14. Optoelektronisches Halbleiterbauteil (1) nach einem der vorhergehenden Ansprüche,
bei dem das Vergussmaterial (4) ein strahlungsdurchlässiges Matrixmaterial und in das Matrixmaterial eingebettete, reflektierende Partikel umfasst,
wobei das Matrixmaterial ein Silikon und/oder ein Epoxid enthält oder hieraus besteht und die Partikel mindestens ein Metalloxid enthalten oder hieraus bestehen,
wobei ein im Halbleiterchip (3) im Betrieb erzeugter Strahlungsanteil in lateraler Richtung das Substrat (34) verlässt und höchstens 300 µm in das Vergussmaterial (4) eindringt und das Vergussmaterial (4) dazu eingerichtet ist, den Strahlungsanteil mindestens teilweise diffus in das Substrat (34) zurück zu reflektieren, und
wobei ein mittlerer Durchmesser der Partikel zwischen einschließlich 0,3 µm und 5 µm und ein Gewichtsanteil der Partikel an dem gesamten Vergussmaterial (4) zwischen einschließlich 10 % und 30 % liegt und die Partikel reflektierend aufgrund ihrer weißen Farbe und/oder aufgrund ihres Brechungsindexunterschieds zu dem Matrixmaterial wirken.

15. Optoelektronisches Halbleiterbauteil (1) nach einem der vorhergehenden Ansprüche,
bei dem das strahlungsdurchlässigen Substrat (34) ein Aufwachssubstrat für die Halbleiterschichtenfolge (32) ist.

## Claims

1. Optoelectronic semiconductor component (1) with
- a carrier (2) with a carrier top (20),
- at least one optoelectronic semiconductor chip (3) mounted on the carrier top (20) and having a radiation-transmissive substrate (34) and a semiconductor layer sequence (32) which comprises at least one active layer for generating electromagnetic radiation,
- a conversion medium (6) applied directly as a layer or indirectly as a plate via a connecting means on a main radiation side (30), remote from the carrier (2), of the semiconductor chip (3) for at least partially converting the radiation emitted by the semiconductor chip (3) into a radiation of another wavelength, and
- a reflective potting material (4), which surrounds the semiconductor chip (3) directly and form-fittingly in a lateral direction,
**characterized in that**
the conversion medium (6) is located between the potting material (4) and the main radiation side (30), such that both the semiconductor chip (3) and the conversion medium (6) are completely covered by the potting material (4).

2. Optoelectronic semiconductor component (1) according to the preceding claim,
in which the substrate (34) is located between the carrier (2) and the semiconductor layer sequence (32), and which comprises at least one electrical connection means (5) which produces an electrical connection between the carrier top (20) or electrical connection zones located on the carrier top (20) and the main radiation side (30).

3. Optoelectronic semiconductor component (1) according to one of the preceding claims,
in which the conversion medium (6) has a greater lateral extent than thickness and the thickness is between 10 µm and 150 µm inclusive.

4. Optoelectronic semiconductor component (1) according to one of the preceding claims,
in which the carrier (2) comprises a cavity (25) and a base surface of the cavity (25) constitutes the carrier top (20),
wherein the semiconductor chip (3) and the potting material (4) are located in the cavity (25),
wherein the reflective potting material (4) has a wetting action relative to the lateral boundary walls of the cavity (25), such that the potting material (4) forms a paraboloidal reflector within the cavity (25).

5. Optoelectronic semiconductor component (1) according to one of the preceding claims,
in which a thickness of the semiconductor layer sequence (32) amounts to at most 12 µm and a thickness of the radiation-transmissive substrate (34) amounts to between 40 µm and 500 µm inclusive.

6. Optoelectronic semiconductor component (1) according to claims 2 and 3,
in which, in a direction perpendicular to the carrier top (20), the semiconductor chip (3) and the potting material (4) are covered by the electrical connection means (5), which passes through the conversion medium (6).

7. Optoelectronic semiconductor component (1) according to one of claims 1 to 5,
in which the connection means (5) is embedded at least in places in the potting material (4).

8. Optoelectronic semiconductor component (1) according at least to claim 2,
in which the potting material (4) at least in places directly and form-fittingly surrounds the semiconductor chip (3) and the at least one electrical connection means (5) in the lateral direction.

9. Optoelectronic semiconductor component (1) according at least to claim 2,
in which the electrical connection means (5) is applied in places directly to a top (40) of the potting material (4) remote from the carrier.

10. Optoelectronic semiconductor component (1) according to claims 2 and 3,
in which the electrical connection means (5) is applied in places directly to a top (60) of the conversion medium (6) remote from the carrier.

11. Optoelectronic semiconductor component (1) according to claim 2,
in which the electrical connection zones (7) are arranged on the carrier top (20) laterally beside the semiconductor chip (3) and comprise a material which absorbs radiation generated when the semiconductor chip (3) is in operation, wherein the electrical connection zones (7) are shielded from the radiation by the potting material (4).

12. Optoelectronic semiconductor component (1) according to one of the preceding claims,
in which the main radiation side (30) is covered in places or completely with a non-stick layer which is designed to prevent the potting material (4) from wetting the main radiation side (30).

13. Optoelectronic semiconductor component (1) according to one of the preceding claims,
in which the potting material (4) is designed to reduce the emission angle of the radiation generated when the semiconductor chip (3) is in operation.

14. Optoelectronic semiconductor component (1) according to one of the preceding claims,
in which the potting material (4) comprises a radiation-transmissive matrix material and reflective particles embedded in the matrix material,
wherein the matrix material contains or consists of a silicone and/or an epoxide and the particles contain or consist of at least one metal oxide,
wherein a fraction of the radiation generated in the semiconductor chip (3) when in operation leaves the substrate (34) in the lateral direction and penetrates by at most 300 µm into the potting material (4) and the potting material (4) is designed to reflect at least some of the fraction of radiation diffusely back into the substrate (34), and
wherein an average diameter of the particles is between 0.3 µm and 5 µm inclusive and the proportion by weight of the particles in the entire potting material (4) is between 10 % and 30 % inclusive and the particles have a reflective action due to their white color and/or due to their refractive index difference relative to the matrix material.

15. Optoelectronic semiconductor component (1) according to one of the preceding claims,
in which the radiation-transmissive substrate (34) is a growth substrate for the semiconductor layer sequence (32).

## Revendications

1. Composant semi-conducteur (1) optoélectronique comprenant
- un support (2) muni d'un côté supérieur (20) de support,
- au moins une puce à semi-conducteur (3) optoélectronique placée sur le côté supérieur (20) de support, munie d'un substrat (34) perméable au rayonnement et munie d'une succession de couches semi-conductrices (32), laquelle présente au moins une couche active destinée à générer un rayonnement électromagnétique,
- un moyen de conversion (6) appliqué, directement en tant que couche ou indirectement, par l'intermédiaire d'un moyen de liaison, en tant que plaquette, sur un côté principal de rayonnement (30) de la puce à semi-conducteur (3), détourné du support (2), pour une conversion au moins partielle du rayonnement émis par la puce à semi-conducteur (3) en un rayonnement d'une autre longueur d'onde, et
- une matière d'enrobage (4) réfléchissante qui entoure la puce à semi-conducteur (3) dans une direction latérale, directement tout autour et par adhérence de forme,
**caractérisé en ce que**
le moyen de conversion (6) se trouve entre la matière d'enrobage (4) et le côté principal de rayonnement (30) de sorte qu'aussi bien la puce à semi-conducteur (3) que le moyen de conversion (6) sont complètement recouverts par la matière d'enrobage (4).

2. Composant semi-conducteur (1) optoélectronique selon la revendication précédente,
dans lequel le substrat (34) se trouve entre le support (2) et la succession de couches semi-conductrices (32), et lequel comprend au moins un dispositif de connexion électrique (5) qui établit une connexion électrique entre le côté supérieur (20) du support ou des zones de connexion électrique se trouvant sur le côté supérieur (20) du support et le côté principal de rayonnement (30).

3. Composant semi-conducteur (1) optoélectronique selon l'une quelconque des revendications précédentes,
dans lequel le moyen de conversion (6) présente une extension latérale plus grande qu'une épaisseur et dans lequel l'épaisseur est située entre, y compris, 10 µm et 150 µm.

4. Composant semi-conducteur (1) optoélectronique selon l'une quelconque des revendications précédentes,
dans lequel le support (2) présente une cavité (25) et dans lequel une surface de sol de la cavité (25) représente le côté supérieur (20) du support,
la puce à semi-conducteur (3) et la matière d'enrobage (4) se trouvant dans la cavité (25),
la matière d'enrobage (4) réfléchissante agissant de manière mouillante en ce qui concerne des parois latérales de délimitation de la cavité (25), de sorte qu'un réflecteur paraboloïde est réalisé à l'intérieur de la cavité (25) au moyen de la matière d'enrobage (4).

5. Composant semi-conducteur (1) optoélectronique selon l'une quelconque des revendications précédentes,
dans lequel une épaisseur de la succession de couches semi-conductrices (32) est au maximum de 12 µm et dans lequel une épaisseur du substrat (34) perméable au rayonnement est comprise entre, y compris, 40 µm et 500 µm.

6. Composant semi-conducteur (1) optoélectronique selon les revendications 2 et 3,
dans lequel, dans une direction perpendiculaire au côté supérieur (20) du support, la puce à semi-conducteur (3) ainsi que la matière d'enrobage (4) sont recouvertes par le dispositif de connexion (5) électrique qui traverse le moyen de conversion (6).

7. Composant semi-conducteur (1) optoélectronique selon l'une quelconque des revendications 1 à 5,
dans lequel le dispositif de connexion (5) est incorporé dans la matière d'enrobage (4) au moins par endroits.

8. Composant semi-conducteur (1) optoélectronique selon au moins la revendication 2,
dans lequel la matière d'enrobage (4) entoure la puce à semi-conducteur (3) et l'au moins un dispositif de connexion (5) électrique, en direction latérale, au moins par endroits directement et par adhérence de forme.

9. Composant semi-conducteur (1) optoélectronique selon au moins la revendication 2,
dans lequel le dispositif de connexion (5) électrique est appliqué par endroits directement sur un côté supérieur (40) de la matière d'enrobage (4), détourné du support.

10. Composant semi-conducteur (1) optoélectronique selon les revendications 2 et 3,
dans lequel le dispositif de connexion (5) électrique est appliqué par endroits directement sur un côté supérieur (60) du moyen de conversion (6), détourné du support.

11. Composant semi-conducteur (1) optoélectronique selon la revendication 2,
dans lequel les zones de connexion (7) électriques sont disposées sur le côté supérieur (20) du support, latéralement à côté de la puce à semi-conducteur (3), et présentent une matière absorbante pour le rayonnement généré pendant le fonctionnement de la puce à semi-conducteur (3),
les zones de connexion (7) électriques étant protégées du rayonnement par la matière d'enrobage(4).

12. Composant semi-conducteur (1) optoélectronique selon l'une quelconque des revendications précédentes,
dans lequel le côté principal de rayonnement (30) est recouvert par endroits ou intégralement par une couche antiadhésive qui est conçue pour empêcher un mouillage du côté principal de rayonnement (30) par la matière d'enrobage (4).

13. Composant semi-conducteur (1) optoélectronique selon l'une quelconque des revendications précédentes,
dans lequel la matière d'enrobage (4) est conçue pour réduire un angle de rayonnement du rayonnement généré pendant le fonctionnement de la puce à semi-conducteur (3).

14. Composant semi-conducteur (1) optoélectronique selon l'une quelconque des revendications précédentes,
dans lequel la matière d'enrobage (4) est une matière de matrice perméable au rayonnement et comprend des particules réfléchissantes incorporées dans la matière de matrice,
la matière de matrice contenant un silicone et/ou un époxyde ou en étant constituée, et les particules contenant au moins un oxyde métallique ou en étant constituées,
une proportion de rayonnement générée dans la puce à semi-conducteur (3) pendant le fonctionnement quittant le substrat (34) en direction latérale et pénétrant au maximum de 300 µm dans la matière d'enrobage (4), et la matière d'enrobage (4) étant conçue pour refléter en retour dans le substrat (34) la proportion de rayonnement au moins partiellement de manière diffuse, et
un diamètre moyen des particules étant situé entre, y compris, 0,3 µm et 5 µm et une proportion en poids des particules par rapport à la totalité de la matière d'enrobage (4) étant située entre, y compris, 10 % et 30 %, et les particules agissant de manière réfléchissante en raison de leur couleur blanche et/ou en raison de leur différence d'indice de réfraction par rapport à la matière de matrice.

15. Composant semi-conducteur (1) optoélectronique selon l'une quelconque des revendications précédentes,
dans lequel le substrat (34) perméable au rayonnement est un substrat de croissance pour la succession de couches semi-conductrices (32).
